(19) Europäisches Patentamt
European Patent Office
Office européen des brevets

(11) **EP 3 005 413 B1**

(12) **EUROPÄISCHE PATENTSCHRIFT**

(45) Veröffentlichungstag und Bekanntmachung des Hinweises auf die Patenterteilung:
**06.07.2022 Patentblatt 2022/27**

(21) Anmeldenummer: **14726957.5**

(22) Anmeldetag: **26.05.2014**

(51) Internationale Patentklassifikation (IPC):
***H01L 21/67*** (2006.01)

(52) Gemeinsame Patentklassifikation (CPC):
**H01L 21/67115**

(86) Internationale Anmeldenummer:
**PCT/EP2014/060832**

(87) Internationale Veröffentlichungsnummer:
**WO 2014/195172 (11.12.2014 Gazette 2014/50)**

(54) **BETRIEBSVERFAHREN UND VORRICHTUNG ZUR BESTRAHLUNG EINES SUBSTRATS**

OPERATING METHOD AND DEVICE FOR IRRADIATING A SUBSTRATE

PROCÉDÉ DE FONCTIONNEMENT ET DISPOSITIF D'INSOLATION D'UN SUBSTRAT

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **07.06.2013 DE 102013105959**

(43) Veröffentlichungstag der Anmeldung:
**13.04.2016 Patentblatt 2016/15**

(73) Patentinhaber: **Heraeus Noblelight GmbH 63450 Hanau (DE)**

(72) Erfinder:
• **WEBER, Jürgen 63801 Kleinostheim (DE)**
• **LINOW, Sven 64285 Darmstadt (DE)**
• **WEISS, Oliver 63150 Heusenstamm (DE)**

(74) Vertreter: **Heraeus IP Heraeus Business Solutions GmbH Intellectual Property Heraeusstraße 12-14 63450 Hanau (DE)**

(56) Entgegenhaltungen:
EP-A2- 2 059 089      WO-A1-2012/009636
WO-A2-2007/025376    JP-A- 2005 115 350
US-A1- 2008 190 909    US-A1- 2010 213 186

**Beschreibung**

Die vorliegende Erfindung betrifft ein Verfahren zum Betreiben einer Vorrichtung zur Modifizierung eines Substrats gemäß Anspruch 1.

Weiterhin betrifft die vorliegende Erfindung eine Vorrichtung zur Modifizierung eines Substrats gemäß Anspruch 10.

Technischer Hintergrund

Vorrichtungen zur Modifizierung eines Substrats im Sinne der Erfindung sind Infrarot-Wärmevorrichtungen; sie werden beispielsweise zum Trocknen und Aushärten von Beschichtungen, Klebstoffen oder Farben verwendet.

Stand der Technik

Bekannte Vorrichtungen weisen eine Prozesskammer zur Aufnahme des Substrats sowie mehrere Infrarotstrahler zur Bestrahlung des Substrats auf. Die Infrarotstrahler bestehen in der Regel aus einem beidseitig verschlossenen Leuchtrohr aus Quarzglas, in dem ein Heizelement, beispielsweise in Form eines Carbonbandes oder eines Wolframdrahts, angeordnet ist. Das Leuchtrohr der Infrarotstrahler ist mit einem Inertgas gefüllt.

Eine derartige Bestrahlungsvorrichtung ist beispielsweise aus der DE 100 51 125 A1 bekannt, die eine Schnellheizanlage für Halbleiterwafer offenbart. Die Bestrahlungsvorrichtung weist eine drehbar gelagerte Aufnahme für ein Substrat, sowie mehrere Infrarotstrahler mit einem linearen, zylindrisch-gestreckten Strahlerrohr auf, in dem ein Glühdraht aus Wolfram angeordnet ist. Darüber hinaus ist eine Regeleinheit zur individuellen elektrischen Ansteuerung der Infrarotstrahler vorgesehen, durch die die Bestrahlungsleistung der Infrarotstrahler eingestellt werden kann.

Die Einstellbarkeit der Bestrahlungsleistung ermöglicht eine Optimierung des Bestrahlungsprozesses. Grundsätzlich wird ein schneller Bestrahlungsprozess ermöglicht, wenn die Bestrahlungsleistung der Infrarotstrahler möglichst hoch gewählt wird, so dass ein hoher Energieeintrag in das Substrat erfolgt. Allerdings hängt die bei einem Bestrahlungsprozess maximal einsetzbare Bestrahlungsleistung von dem zu bestrahlenden Substrat ab. Häufig ist das Substrat temperaturempfindlich, so dass eine zu hohe Bestrahlungsleistung mit einer zu starken Erwärmung und einer Beschädigung des Substrats einhergeht. Darüber hinaus beeinflusst auch das Strahlungsspektrum der Infrarotstrahler den Bestrahlungsvorgang. Häufig weisen thermisch empfindliche Substrate ein stark wellenlängenabhängiges Absorptionsspektrum auf, so dass für eine effiziente Bestrahlung des Substrats Strahlung mit einem hohen Strahlungsanteil in bestimmten Wellenlängenbereichen notwendig ist. Dabei entscheidet das von den Infrarotstrahlern emittierte Spektrum mitunter darüber, ob ein Bestrahlungsverfahren überhaupt durchgeführt werden kann.

Um eine Bestrahlungsvorrichtung für die Bestrahlung verschiedener Substrate einsetzen zu können, ist es daher notwendig unterschiedliche Emissionsspektren erzeugen zu können. Hierbei ist es üblich die Bestrahlungsvorrichtung auf andere Infrarotstrahler umzurüsten. Dies setzt aber einerseits ein kostenintensives Vorrätighalten mehrerer Infrarotstrahler mit unterschiedlichen Emissionsspektren voraus, andererseits wird für das Umrüsten der Infrarotstrahler eine gewisse Umrüst-zeit benötigt, wodurch die Produktivität bei einem Wechsel auf die Bestrahlung eines anderen Substrats beeinträchtigt werden kann.

Ein besonderes Anwendungsgebiet für die erfindungsgemäße Bestrahlungsvorrichtungen stellt das Trocknen und Sintern metallhaltiger Tinte dar, wie es bei der Herstellung gedruckter Elektronik, beispielsweise von elektronischen Schaltelementen, RFIDs, organischer Photovoltaik, OLEDs oder Printed Batteries, eingesetzt wird. Bei der Herstellung gedruckter Elektronik wird zunächst in einem ersten Verfahrensschritt die metallhaltige Tinte mittels eines Druckverfahrens als dünne Schicht auf ein geeignetes Substrat, beispielsweise auf eine Plastikfolie, ein Papier oder Glas, aufgebracht. Die Dicke der Tintenschicht liegt in der Regel zwischen 0,3 $\mu$m und 3,0 $\mu$m. Für das Aufbringen der Tintenschicht können eine Vielzahl verschiedener Druckverfahren eingesetzt werden. Häufig finden der Siebdruck, das Rolle-zu-Rolle-Verfahren oder der Tintenstrahldruck (*ink-jet printing*) Anwendung.

Tinten, die bei der Herstellung von gedruckter Elektronik eingesetzt werden, enthalten einen hohen Anteil kleiner Metallpartikel, deren Teilchengröße häufig im Nanometerbereich liegt. Die Metallpartikel sind in einem wässrigen oder organischen Dispersionsmittel dispergiert. Darüber hinaus können die Tinten organische Zusätze enthalten, etwa zur besseren Partikelvernetzung, Löslichkeit, Benetzbarkeit oder zur Verhinderung von Agglomeration, aber auch wässrige Zusätze zur besseren Verarbeitbarkeit der Tinten. Um eine elektrisch leitfähige und dauerhafte Beschichtung des Substrats zu erhalten, ist es notwendig die Tintenbeschichtung in einem zweiten Verfahrensschritt mit der Bestrahlungsvorrichtung zu trocknen und zu sintern.

Eine solche Bestrahlungsvorrichtung für die Herstellung gedruckter Elektronik ist beispielsweise aus der US 2010/0003021 A1 bekannt. Diese Vorrichtung weist eine Strahlungsquelle auf, die zur Emission von Strahlung mit Wellenlängen im sichtbaren, Infrarot- und/oder UV-Bereich geeignet ist. Darüber hinaus umfasst die Vorrichtung eine Regeleinheit zur Regelung der Bestrahlung in Abhängigkeit von optischen Eigenschaften der aushärtenden Beschichtung. Die Regeleinheit erfasst optisch den Grad der Aushärtung der Beschichtung und regelt in Abhängigkeit hiervon die von den Strahlungsquellen insgesamt emittierte Bestrahlungsleistung.

Auch bei dieser Vorrichtung ist regelmäßig ein Umrüsten der Infrarotstrahler notwendig, wenn diese für die Bestrahlung unterschiedlicher Substrate eingesetzt werden soll.

Aus der Druckschrift EP 2 059 089 A2 ist eine Bestrahlungsvorrichtung für Wafer mit einer Vielzahl individuell ansteuerbarer Multifilament-Infrarotlampen bekannt. Die Multifilament-Infrarotlampen sind in Gruppen zusammengefasst, die jeweils einer bestimmten Zone des Substrats zugeordnet sind. Die Zusammenfassung in Gruppen dient der Erzielung einer gleichmäßigen Temperaturverteilung; sie erleichtert darüber hinaus die Ansteuerung der Infrarotlampen.

## Technische Aufgabe

Der Erfindung liegt daher die Aufgabe zugrunde, ein effizientes Betriebsverfahren anzugeben, das eine einfache und schnelle Umrüstung der Vorrichtung auf eine neue Betriebsart und gleichzeitig einen einfachen und kostengünstigen Betrieb der Vorrichtung ermöglicht.

Weiterhin liegt der Erfindung die Aufgabe zugrunde, eine Vorrichtung bereitzustellen, die einfach und schnell auf eine neue Betriebsart umgerüstet werden kann und darüber hinaus einfach und kostengünstig betrieben werden kann.

## Allgemeine Beschreibung der Erfindung

Hinsichtlich des Betriebsverfahrens wird diese Aufgabe ausgehend von einem Betriebsverfahren für eine Vorrichtung zur Modifizierung eines Substrats der eingangs genannten Gattung erfindungsgemäß dadurch gelöst, dass in Abhängigkeit von der zu erzielenden Modifizierung des Substrats ein Soll-Strahlungsspektrum vorgegeben wird, die jeweiligen Soll-Betriebsleistungen der Infrarotstrahler von einer Regeleinheit individuell ermittelt und gewählt und die Betriebsleistungen der Infrarotstrahler mit der Regeleinheit auf die jeweilige Soll-Betriebsleistung geregelt werden, so dass sich aus ihrer Addition das Soll-Strahlungsspektrum und eine Gesamtbestrahlungsleistung ergibt, die von dem vorgegebenen Soll-Wert der Gesamtbestrahlungsleistung um maximal 15 % abweicht, wobei die Infrarotstrahler baugleich sind.

Vorrichtungen, die zur Modifizierung eines Substrats eingesetzt werden, weisen eine Bestrahlungseinheit auf, die das Substrat mit Infrarotstrahlung bestrahlt. Bei diesen Vorrichtungen sind regelmäßig die Bestrahlungseinheit und das Substrat relativ zueinander bewegbar. Die von der Bestrahlungseinheit emittierte Strahlung ist einerseits durch ihre Bestrahlungsleistung und andererseits durch ihr Strahlungsspektrum charakterisiert.

Die Gesamtbestrahlungsleistung beeinflusst die Erwärmung des Substrats während der Bestrahlung; sie legt das Temperaturmaximum fest, welches das Substrat während der Bestrahlung aufweist. Eine zu hohe Gesamtbestrahlungsleistung kann grundsätzlich mit der Beschädigung des Substrats einhergehen.

Das Strahlungsspektrum hingegen beeinflusst die Effektivität des Bestrahlungsprozesses. Häufig ist für einen effektiven Bestrahlungsprozess Strahlung mit einem hohen Strahlungsanteil in einem vorgegebenen Wellenlängenbereich nötig. Insbesondere bei thermisch empfindlichen Substraten, die ein stark wellenlängenabhängiges Absorptionsspektrum aufweisen oder aus mehreren Komponenten mit unterschiedlichen spektralen Eigenschaften zusammengesetzt sind, kann das Emissionsspektrum die Effizienz des Bestrahlungsverfahrens beeinflussen; das erzielte Emissionsspektrum entscheidet mitunter darüber, ob ein Bestrahlungsverfahren überhaupt durchgeführt werden kann.

Für viele Bestrahlungsprozesse ist es daher wünschenswert, sowohl die Gesamtbestrahlungsleistung als auch das Strahlungsspektrum einstellen zu können. Um bei einer Vorrichtung zur Bestrahlung eines Substrats sowohl die Gesamtbestrahlungsleistung als auch das von den Infrarotstrahlern emittierte Strahlungsspektrum einstellen zu können, sind erfindungsgemäß zunächst mehrere Infrarotstrahler vorgesehen, die jeweils mit einer individuellen Soll-Betriebsleistung betrieben werden können.

Infrarotstrahler gehören zu den thermischen Strahlern, deren Emissionsspektrum im Wesentlichen von der Temperatur ihres Heizelements abhängt. Das Emissionsspektrum weist bei diesen Strahlern bei einer bestimmten Wellenlänge eine maximale Energiedichte auf; die zugehörige Wellenlänge wird als Hauptemissionslinie bezeichnet.

Die Lage der Hauptemissionslinie ist durch die Temperatur des Infrarotstrahlers festgelegt. Die Wellenlänge der Hauptemissionslinie ist umso größer, je kälter der Infrarotstrahler ist. Durch geeignete Wahl der Temperatur des Infrarotstrahlers kann daher die Hauptemissionslinie eingestellt werden. Mit einer Änderung der Temperatur geht gleichzeitig eine Änderung der Wellenlängenverteilung, also des gesamten Spektrums einher. Die Wellenlängenverteilung eines von einem Infrarotstrahler emittierten Spektrums lässt sich näherungsweise durch das Planck'sche Strahlungsgesetz beschreiben. Hiernach kann die spektrale Emissionsleistung eines Materials durch folgende Formel beschrieben werden:

$$E(\lambda, T) = \frac{c_1}{\lambda^5} \frac{\varepsilon(\lambda, T)}{e^{(c_2/\lambda T)} - 1}$$

wobei $E(\lambda, T)$: die spektrale Emissionsleistung, $c_1$, $c_2$: Konstanten, $\lambda$: die Wellenlänge, T: die Temperatur und $\varepsilon(\lambda, T)$ die spektrale Emissivität der Oberfläche sind.

Diese Art der Anpassung des Strahlungsspektrums ist für UV-Strahler grundsätzlich bekannt. So ist aus der DE 101 45 648 A1 eine UV-Bestrahlungsvorrichtung bekannt, deren Strahlungsspektrum einerseits durch mehrere Strahlungsquellen mit unterschiedlichen Emissionsspektren und andererseits durch Anpassung der Betriebsleistung der UV-Strahler eingestellt werden kann. Allerdings kann über eine Änderung der Leistungszufuhr bei UV-Strahlern im Wesentlichen nur die gesamt zugeführte Energiemenge erhöht oder reduziert werden. Die Verteilung der Energie über die Wellenlänge ändert sich hingegen nur geringfügig. Daher kommt bei derartigen Bestrahlungsvorrichtungen dem Vorsehen unterschiedlicher Strahlungsquellen wesentliche Bedeutung zu.

Die UV-Strahler zeigen bei einem Betrieb mit verringerter Betriebsleistung zwar ebenfalls eine geringere Strahler-Temperatur. Allerdings beruht hier die Anpassung des Spektrums darauf, dass durch die Temperaturänderung die Gaszusammensetzung im Entladungsraum des UV-Strahlers verändert wird, beispielsweise indem die metallischen Zusätze des Füllgases im Entladungsraum kondensieren; sie kann daher auf Infrarotstrahler nicht ohne Weiteres übertragen werden. Zwar ist auch bei Infrarotstrahlern das Leuchtrohr häufig mit einem Inertgas gefüllt, so dass eine hohe Temperatur des Heizelements und damit eine hohe Leistung des Infrarotstrahlers ermöglicht werden. Das Inertgas trägt jedoch nicht nennenswert zur Emission im infraroten Spektralbereich bei und eine Veränderung der Gaszusammensetzung beim Abkühlen der Infrarotstrahler wird nicht beobachtet.

Die in der Bestrahlungseinheit angeordneten Infrarotstrahler weisen jeweils ein individuelles Emissionsspektrum und eine individuelle Bestrahlungsleistung auf. Bezogen auf die gesamte Bestrahlungseinheit überlagern sich die individuellen Strahlungsspektren der Infrarotstrahler unter Ausbildung eines Mischspektrums. Die Gesamtbestrahlungsleistung ist die integrale Bestrahlungsleistung in Watt bezogen auf die Emissionsfläche der Strahleranordnung. Da sich die Gesamtbestrahlungsleistung der Bestrahlungseinheit aus der Summe der Einzelbestrahlungsleistungen ergibt, kann durch eine Variation der Strahleranzahl die Gesamtbestrahlungsleistung eingestellt werden. Dabei können die Infrarotstrahler sowohl mit gleichen Betriebsleistungen als auch mit unterschiedlichen Betriebsleistungen betrieben werden, so dass das Substrat bedingt durch die Überlagerung der Spektren mit einem Mischspektrum bestrahlt wird, welches dem vorgegeben Strahlungsspektrum entspricht.

Dadurch, dass erfindungsgemäß mehrere Infrarotlampen vorgesehen sind, können einzelne Infrarotstrahler ausgeschaltet oder zugeschaltet werden, um das gewünschte Strahlungsspektrum und gleichzeitig die vorgegebene Gesamtbestrahlungsleistung zu erhalten. Insbesondere können die Infrarotstrahler mit einer geringeren Betriebsleistung betrieben werden (gedimmter Betrieb). Die Infrarotstrahler sind individuell ansteuerbar und werden mit ihrer jeweiligen Betriebsleistung betrieben.

Darüber hinaus ist eine Vorrichtung mit mehreren baugleichen Infrarotstrahlern einfach herzustellen; sie ermöglicht eine einfache Regelung der jeweiligen Infrarotstrahler Betriebsleistungen, da hierbei nur ein Infrarotstrahler-Typ berücksichtigt werden muss. Dadurch, dass nicht verschiedene Infrarotstrahler vorrätig gehalten werden müssen, werden Investitions- und Betriebskosten gering gehalten. Erfindungsgemäß ist eine Regeleinheit vorgesehen, die unter Vorgabe des einzustellenden Strahlungsspektrums und einem vorgegebenen Soll-Wert der einzustellenden Gesamtbestrahlungsstärke die jeweiligen Betriebsleistungen der einzelnen Infrarotstrahler ermittelt.

In einer vorteilhaften Ausgestaltung des erfindungsgemäßen Betriebsverfahrens ist vorgesehen, dass die Infrarotstrahler eine Nennleistung aufweisen, und dass die jeweiligen Soll-Betriebsleistungen entweder 0% der Nennleistung betragen oder im Bereich von 15% bis einschließlich 100% der Nennleistung liegen.

Die Nennleistung des Infrarotstrahlers ist die maximale Leistung, mit der dieser bei bestimmungsgemäßem Betrieb ohne wesentliche Beeinträchtigung der Lebensdauer dauerhaft betrieben werden kann. Die Betriebsleistung, mit der der jeweilige Infrarotstrahler tatsächlich betrieben wird, lässt sich als prozentualer Anteil der Nennleistung ausdrücken.

Ein gedimmter Betrieb der Infrarotstrahler kann die Effizienz der Infrarotstrahler beeinträchtigen. Um einen effizienten Betrieb der Vorrichtung zu gewährleisten, hat es sich bewährt, wenn die Infrarotstrahler entweder mit einer Betriebsleistung betrieben werden, die im Bereich von 15% bis einschließlich 100% der Nennleistung liegt, oder ausgeschaltet sind, das heißt mit 0% der Nennleistung betrieben werden.

Ein besonders effizienter Betrieb der Vorrichtung wird gewährleistet, wenn die jeweiligen Soll-Betriebsleistungen entweder 0% der Nennleistung betragen oder im Bereich von 50% bis einschließlich 100% der Nennleistung liegen.

In einer weiteren vorteilhaften Ausgestaltung des erfindungsgemäßen Betriebsverfahrens ist vorgesehen, dass die Infrarotstrahler jeweils Strahlung mit einem Anteil an IR-A-Strahlung von mindestens 25% und IR-B-Strahlung von mindestens 25% bezogen auf die gesamte Strahlungsleistung des jeweiligen Infrarotstrahlers emittieren.

IR-A-Strahlung weist Wellenlängen im Bereich von 0,78 $\mu$m bis 1,4 $\mu$m auf; die Wellenlängen von IR-B-Strahlung liegen im Bereich von 1,4 $\mu$m bis 3,0 $\mu$m und die von IR-C-Strahlung im Bereich von 3 $\mu$m bis 1000 $\mu$m. Infrarotstrahlung im IR-A-Bereich weist im Vergleich zu IR-B-Strahlung eine höhere Strahlungsenergie auf. Grundsätzlich gilt: Je größer die Strahlungsenergie, desto kürzer kann der Bestrahlungsvorgang gewählt werden. Der IR-A-Strahlungsanteil trägt daher zu einem effizienten Betriebsverfahren bei. IR-B-Strahlung wird von vielen Substraten gut absorbiert. Gute Bestrahlungsergebnisse werden daher erzielt, wenn die Infrarotstrahler Strahlung mit einem Strahlungsanteil an IR-A-Strahlung von mindestens 25% und einem Strahlungsanteil an IR-B-Strahlung von mindestens 25% aufweisen.

Es hat sich bewährt, wenn die Soll-Betriebsleistung der Infrarotstrahler von einer Regeleinheit ermittelt wird.

Dadurch, dass die Regeleinheit den Soll-Wert der Betriebsleistung ermittelt, kann dieser leicht an veränderte Betriebsbedingungen angepasst werden. Der Soll-Wert der Betriebsleistung steht unmittelbar für eine entsprechende Regelung der Betriebsleistung zur Verfügung.

Bei einer bevorzugten Modifikation des erfindungsgemäßen Betriebsverfahrens ist vorgesehen, dass die Vorrichtung unbeleuchtete Infrarotstrahler und beleuchtete Infrarotstrahler umfasst, wobei benachbarte beleuchtete Infrarotstrahler einen Beleuchtungsabstand zueinander aufweisen, wobei die Varianz des Mittelwerts der Beleuchtungsabstände der Vorrichtung ein Minimum einnimmt.

Bei einer Vorrichtung mit mehreren Infrarotstrahlern müssen zur Einstellung der Gesamtbestrahlungsstärke und des Strahlungsspektrums müssen nicht alle Infrarotstrahler beleuchtet sein. Die beleuchteten Infrarotstrahler bestrahlen dabei ein Bestrahlungsfeld auf der Oberfläche des Substrats. Benachbarte beleuchtete Infrarotstrahler schließen unmittelbar aneinander an oder sind von einem oder mehreren unbeleuchteten Infrarotstrahler voneinander getrennt. Der Beleuchtungsabstand ist der kürzeste Abstand der Strahlerrohre benachbarter Infrarotstrahler. Um eine möglichst gleichmäßige Bestrahlung des Bestrahlungsfelds zu ermöglichen sind die beleuchteten Infrarotstrahler in der Vorrichtung derart angeordnet, dass der Mittelwert der Beleuchtungsabstände eine möglichst geringe Streuung aufweist.

Es hat sich als günstig erwiesen, wenn die Regeleinheit ein Speicherelement aufweist, in dem Kennlinien der Infrarotstrahler hinterlegt sind, und wenn mindestens eine der Kennlinien bei der Ermittlung der Soll-Werte der jeweiligen Betriebsleistungen der Infrarotstrahler berücksichtigt wird.

Das Speicherelement ist vorzugsweise ein elektronisches Speicherelement, beispielsweise ein EEPROM oder Flash-Speicher. In dem Speicherelement sind Kennlinien der Infrarotstrahler hinterlegt, die für den jeweiligen Infrarotstrahler charakteristisch sind. Kennlinien in diesem Sinne sind beispielsweise Strom-Spannungskennlinien, Strahlungsleistungs-Temperatur-Kennlinien, Emissionsspektren, Absorptionskurven, Reflexionskurven. Die Regeleinheit ermittelt aus den Kennlinien die einzelnen Betriebsleistungen der jeweiligen Infrarotstrahler und daraus die zu erwartende Gesamtbestrahlungsleistung sowie das Misch-Strahlungsspektrum.

In diesem Zusammenhang hat es sich als vorteilhaft erwiesen, wenn die Kennlinien mindestens eine Strom-Spannungs-Kennlinie umfassen, aus der für den jeweiligen Infrarotstrahler der Betriebsstrom $I_i$ ermittelt wird, so dass bei vorgegebener Betriebsspannung $U_i$ und Betrieb einer Anzahl von Infrarotstrahlern n die Gesamtbestrahlungsleistung erreicht wird.

Die Gesamtbestrahlungsleistung $P_{ges}$ ergibt sich aus der Summe der jeweiligen Betriebsleistungen $P_i$ der Infrarotstrahler. Es gilt:

$$P_{ges} = \sum_{i=1}^{n} P_i .$$

Die jeweilige Betriebsleistung ergibt sich aus der Betriebsspannung $U_i$ und dem Betriebsstrom $I_i$:

$$P_i = U_i * I_i.$$

Ist die Betriebsspannung $U_i$ vorgegeben, kann für den jeweiligen Infrarotstrahler mittels einer Strom-Spannungs-Kennlinie sowohl die Betriebsspannung $I_i$ als auch die Betriebsleistung $P_i$ ermittelt werden. Darüber hinaus wird eine Ermittlung der Anzahl von Infrarotstrahlern n ermöglicht, die für eine vorgegebene Gesamtbestrahlungsleistung benötigt werden. Dabei können die Infrarotstrahler mit der gleichen Betriebsleistung oder mit unterschiedlichen Betriebsleistungen betrieben werden.

Bei einer vorteilhaften Ausgestaltung des erfindungsgemäßen Betriebsverfahrens liegt die mittlere Leistungsdichte auf einer Strahlerebene im Bereich von 20 kW/m$^2$ bis 250 kW/m$^2$.

Die Leistungsdichte auf der Strahlerebene beeinflusst die Bestrahlungsdichte auf dem Substrat. Um einerseits eine möglichst hohe Prozessgeschwindigkeit des Bestrahlungsprozesses zu ermöglichen und andererseits ein Beschädigung des Substrats aufgrund einer zu hohen Bestrahlungsdichte zu vermeiden, hat sich für die meisten Substrate eine Leistungsdichte auf der Strahlerebene im oben genannten Bereich als günstig erwiesen.

In einer anderen, ebenso vorteilhaften Ausgestaltung des erfindungsgemäßen Betriebsverfahrens wird das Bestrahlungsfeld mit einer mittleren Bestrahlungsdichte im Bereich von 10 kW/m$^2$ bis 200 kW/m$^2$ bestrahlt.

Die mittlere Bestrahlungsdichte bezogen auf das Bestrahlungsfeld hat Einfluss auf die Energieeffizienz der Vorrichtung und die Geschwindigkeit des Bestrahlungsprozesses; sie sollte bezogen auf das gesamte Bestrahlungsfeld möglichst gleichmäßig sein. Um eine hohe Prozessgeschwindigkeit zu gewährleisten, ist grundsätzlich eine möglichst hohe Bestrahlungsdichte wünschenswert. Allerdings kann eine mittlere Bestrahlungsdichte von mehr als 200 kW/m$^2$ mit einer starken Erwärmung und einer Beschädigung des Substrats einhergehen. Eine Bestrahlungsdichte von weniger als 10 kW/m$^2$ beeinträchtigt die Prozessgeschwindigkeit; sie geht mit einer geringen Effizienz des Prozesses einher. Darüber hinaus werden mit einer Bestrahlungsdichte im oben angegebenen Bereich gute Ergebnisse beim Trocken, Aushärten und Sintern von Beschichtungen, Klebstoffen oder Farben, insbesondere beim Trocknen und Sintern metallhaltiger Tinte erzielt.

In einer bevorzugten Ausgestaltung des Betriebsverfahrens ist vorgesehen, dass das Substrat mit metallhaltiger Tinte versehen ist und zum Trocknen und Sintern der Tinte bestrahlt wird.

Es ist gängige Meinung, dass gute Verfahrensergebnisse bei der Trocknung und Sinterung metallhaltiger Tinten erzielt werden, wenn hierfür optische Strahler eingesetzt werden, die ein schmalbandiges oder diskretes Emissionsspektrum im sichtbaren oder IR-A-Bereich erzeugen (siehe hierzu: Z. Radivojevic et al.: Optimised curing of silver ink jet based printed traces, Proceedings of 12th International Workshop on Thermal Investigations of ICs -Therminic 2006, Nice: France (2006); R. Cauchois et al.: Impact of variable frequency microwave and rapid thermal sintering on microstructure of inkjet-printed silver nanoparticles, J. Mat. Sci 47, (2012), p. 20; J. West et al.: Photonic Sintering of Silver Nanoparticles: Comparison of Experiment and Theory, in Volodymyr Shatokha [Ed.]: Sintering-Methods and Products. InTech: 2012; A. Khan et al.: Laser sintering of direct write silver nano-ink conductors for microelectronic applications. Proc. SPIE 6879(2008)).

Metallhaltige Tinten sind eine Dispersion fester Metallpartikel in einem Dispersionsmittel. Die Metallpartikel selbst weisen eine hohe Reflektivität für auftreffende IR-B- und IR-C-Strahlung auf. Die von den Infrarotstrahlern emittierte IR-B- und IR-C-Strahlung und die von den Metallpartikeln diffus reflektierte Strahlung verteilt sich innerhalb der zu trocknenden Schicht und steht daher hauptsächlich für eine Bestrahlung der weiteren Bestandteile der metallhaltigen Tinte zur Verfügung. Diese Bestandteile umfassen häufig organische Verbindungen, die gute Absorptionseigenschaften für Strahlung mit Wellenlängen in diesem Bereich aufweisen. Die IR-B- und IR-C-Strahlung wird regelmäßig vom Dispersionsmittel und flüchtigen Substanzen absorbiert, so dass diese Bestandteile verdampfen können. Sie trägt daher zu einer guten Trocknung der Tinte bei, bevor die Metallpartikel in einem Sintervorgang miteinander verbunden werden.

In diesem Zusammenhang hat sich bewährt, wenn die Infrarotstrahler weiterhin Strahlungsanteile im sichtbaren und IR-A-Bereich emittieren. Strahlung mit Wellenlängen in diesem Bereich weist im Vergleich zu IR-B- und IR-C-Strahlung eine höhere Strahlungsenergie auf und ist insbesondere zur Sinterung der Metallpartikel geeignet.

Hinsichtlich der Vorrichtung wird die oben genannte Aufgabe ausgehend von einer Vorrichtung zur Bestrahlung eines Substrats der eingangs genannten Gattung erfindungsgemäß dadurch gelöst, dass zur individuellen Einstellung einer Soll-Betriebsleistung für die jeweiligen Infrarotstrahler eine Regeleinheit vorgesehen ist, die aus einer vorgegebenen Soll-Strahlungsspektrum und einem vorgegebenen Soll-Wert einer Gesamtbestrahlungsleistung die jeweiligen Soll-Betriebsleistungen der Infrarotstrahler individuell ermittelt, so dass sich aus ihrer Addition das Soll-Strahlungsspektrum und eine Gesamtbestrahlungsleistung (Gesamtbetriebsleistung) ergibt, die von dem vorgegebenen Soll-Wert der Gesamtbestrahlungsleistung um maximal 15% abweicht, wobei die Infrarotstrahler baugleich sind.

Die Bestrahlungsvorrichtung weist mehrere Infrarotstrahler mit einem zylinderförmigen Strahlerrohr und einer Strahlerrohr-Längsachse auf, die derart angeordnet sind, dass die Strahlerrohr-Längsachsen parallel zueinander verlaufen. Um bei einer solchen Vorrichtung sowohl die Gesamtbestrahlungsleistung als auch das von den Infrarotstrahlern emittierte Strahlungsspektrum einstellen zu können, sind erfindungsgemäß mehrere Infrarotstrahler und eine Regeleinheit vorgesehen, die die jeweilige Soll-Betriebsleistung der Infrarotstrahler ermittelt.

Die Lage der Hauptemissionslinie und damit das Emissionsspektrum von Infrarotstrahlern sind durch deren Temperatur festgelegt. Mit einer Änderung der Temperatur der Infrarotstrahler geht eine Änderung der Wellenlängenverteilung einher. Da die Temperatur des Infrarotstrahlers von dessen Betriebsleistung abhängt, kann durch geeignete Wahl der Betriebsleistung ein vorgegebenes Strahlungsspektrum eingestellt werden.

Dadurch, dass die erfindungsgemäße Vorrichtung mehrere Infrarotlampen umfasst, ist erfindungsgemäß vorgesehen, dass einzelne Infrarotstrahler mit einer individuellen Soll-Betriebsleistung betrieben werden, um das gewünschte Spektrum zu erhalten. Insbesondere können die Infrarotstrahler mit einer geringeren Betriebsleistung betrieben werden (gedimmter Betrieb). Die Infrarotstrahler sind individuell ansteuerbar. Da sich die Gesamtbestrahlungsleistung aus der Summe der Betriebsleistungen der Infrarotstrahler ergibt, ist darüber hinaus vorgesehen, dass einzelne Infrarotstrahler von der Regeleinheit ausgeschaltet oder zugeschaltet werden können, um die Gesamtbestrahlungsleistung einzustellen. Durch geeignete Wahl der einzelnen Betriebsleistungen wird die Einstellung eines Emissionsspektrums und der Gesamtbestrahlungsleistung ermöglicht.

Die Infrarotstrahler sind in einer gemeinsamen Bestrahlungseinheit angeordnet. Im Gegensatz zu mehreren separaten Strahlern benötigt eine solche Bestrahlungseinheit nur ein gemeinsames Gehäuse für die Infrarotstrahler und trägt so zu einer kompakten Bauform der Vorrichtung bei. Die Infrarotstrahler sind innerhalb der Bestrahlungseinheit mit ihren Strahlerrohr-Längsachsen parallel zueinander angeordnet. Durch die parallele Anordnung der Strahlerrohre wird ein Flächenstrahler erhalten, der für eine flächenhafte Bestrahlung des Substrats mit hohen Bestrahlungsdichten geeignet ist.

Ausführungsbeispiel

Nachfolgend wird die Erfindung anhand von Ausführungsbeispielen und drei Figuren näher beschrieben. Es zeigt in schematischer Darstellung:

**Figur 1** eine nach dem erfindungsgemäßen Betriebsverfahren betreibbare Vorrichtung zur Bestrahlung eines Substrats im Längsschnitt, die vier Zwillingsrohrinfrarotstrahler umfasst,

**Figur 2** eine Schaltungsanordnung für die Heizfilamente der Zwillingsrohrinfrarotstrahler gemäß Figur 1, und

**Figur 3** ein Ablaufdiagramm einer Ausgestaltung des erfindungsgemäßen Betriebsverfahrens.

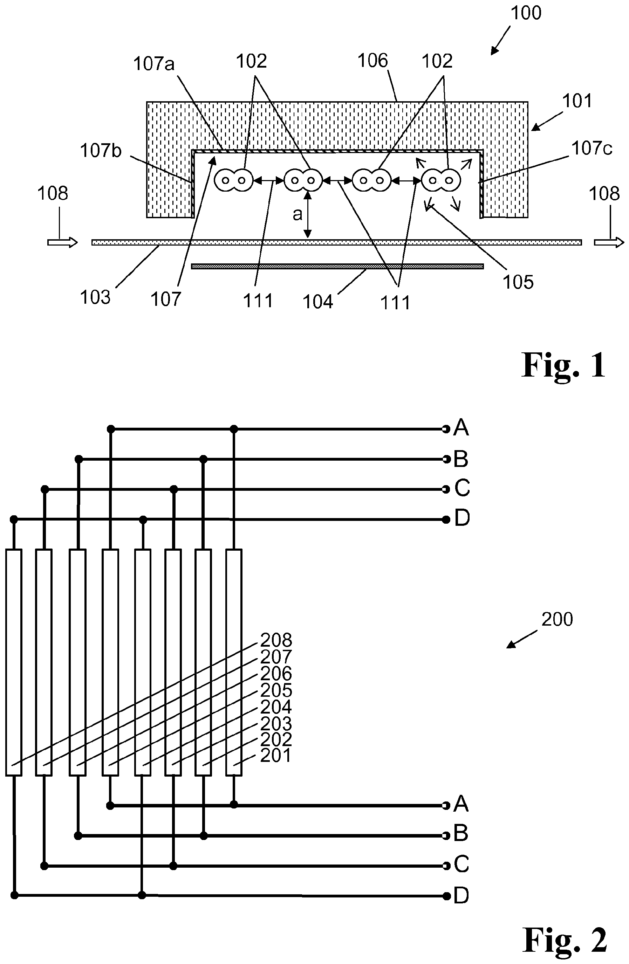

**Figur 1** zeigt schematisch eine Ausführungsform einer Vorrichtung 100 zum Trocknen und Sintern metallhaltiger Tinte auf einem Substrat 103, die nach dem erfindungsgemäßen Verfahren betrieben wird. Die Vorrichtung 100 wird insbesondere zur Trocknung und Sinterung von Tinten in *Printed-Electronics*-Komponenten eingesetzt, die im Rolle-zu-Rolle-Verfahren hergestellt werden.
Die Vorrichtung 100 umfasst ein Strahlermodul 101 mit vier darin angeordneten Infrarotstrahlern 102 zur Emission von optischer Strahlung 105, einen Reflektor 107, sowie einen Spiegel 104 zur Reflexion eines Teils der vom Strahlermodul 101 emittierten Strahlung 105 auf das Substrat 103.
Die Infrarotstrahler 102 sind baugleiche Zwillingsrohrstrahler mit einem zylinderförmigen Strahlerrohr und einer Strahlerrohr-Längsachse; sie sind in dem Strahlermodul 101 derart angeordnet, dass ihre Strahlerrohr-Längsachsen parallel zueinander und senkrecht zu Transportrichtung 108 verlaufen. Als kurzwellige Infrarotstrahler weisen die Infrarotstrahler eine Nenn-Farbtemperatur von etwa 2.200°C auf. Das Emissionsmaximum dieser Strahler 102 liegt bei einer Wellenlänge von etwa 1,2 $\mu$m.
Die Infrarotstrahler 102 emittieren Strahlung mit einem Strahlungsanteil an IR-B-Strahlung von mehr als 25% und im IR-C-Bereich höchstens 13% der jeweiligen Gesamtstrahlerleistung. Im IR-A-Bereich emittieren die Infrarotstrahler jeweils mehr als 25% der Gesamtstrahlerleistung.
Benachbarte Infrarotstrahler 102 weisen einen Abstand 111 zueinander von 55 mm auf. Der Abstand a zwischen der Strahlerunterseite der Infrarotstrahler 102 und dem Substrat beträgt 60 mm. Eine Verstelleinheit (nicht dargestellt) ermöglicht eine einfache Einstellung des Abstands a in einem Bereich von 35 mm bis 185 mm.
Das Strahlermodul 101 weist ein zweiseitig abgewinkeltes Gehäuse 106 mit einer den Infrarotstrahlern 102 zugewandten Seite auf. Auf diese Seite ist der Reflektor 107 aufgebracht. Dadurch, dass der Reflektor 107 ein Basisreflektor 107a und zwei Seitenreflektoren 107b, 107c umfasst, wird ein großer Anteil der von den Infrarotstrahlern 102 emittierten Infrarotstrahlung auf dem Substrat 103 eingekoppelt. Der Reflektor 107 ist aus Aluminium gefertigt und zur Reflexion von Infrarotstrahlung mit einer Wellenlänge im Bereich von 800 nm bis 5.000 nm geeignet. In einer alternativen Ausführungsform (nicht dargestellt) ist auf das Gehäuse eine hochreflektierende Beschichtung aus Aluminium, Silber, Gold, Kupfer, Nickel oder Chrom aufgebracht.
Das Strahlermodul 101 bestrahlt ein Bestrahlungsfeld auf der Oberfläche des Substrats 103. Das Strahlermodul 101 ist für eine Bestrahlung des Bestrahlungsfeldes mit einer mittleren Bestrahlungsdichte von etwa 150 kW/m$^2$ ausgelegt. Das Bestrahlungsfeld weist einen Gesamtflächeninhalt von 1.800 cm$^2$ auf.
Das Substrat 103 ist eine Kunststofffolie aus PET mit einer Folienstärke von 0,1 mm, die von einer Transportvorrichtung (nicht dargestellt) in Transportrichtung 108 relativ zum Strahlermodul 101 bewegt wird. Die Bewegung des Substrats 103 erfolgt mit einer konstanten Vorschubgeschwindigkeit.
Innerhalb des Gehäuses 106 ist ein Kühlelement (nicht dargestellt) zur Kühlung des Reflektors 107 und der Infrarotstrahler 102 vorgesehen. Das Kühlelement ist eine Wasserkühlung. Sie trägt zu einer hohen Lebensdauer der Vorrichtung, insbesondere der Strahler und der Reflektorschicht, bei. In einer alternativen Ausführungsform ist das Kühlelement eine Luftkühlung. Dabei ist das Kühlelement so ausgelegt, dass das Substrat 103 aufgrund seiner geringen thermischen Masse nicht durch einen vom Strahlermodul 101 ausgehenden Luftstrom abgekühlt wird. Dies wird beispielsweise durch eine Luft-Rückkühlung des Reflektors 107 oder eine Luftkühlung der Infrarotstrahler 102 und des Reflektors 107 mit besonderer Luftführung und seitlichem Luftauslass erreicht.
**Figur 2** zeigt eine Schaltungsanordnung 200 für die Heizfilamente 201-208 der Zwillingsrohr-Infrarotstrahler 102 aus Figur 1. Die Heizfilamente 201-208 sind in eine erste Gruppe mit vier Heizfilamenten 205-208 und eine der ersten Gruppe nachgeordnete, zweite Gruppe mit vier Heizfilamenten 201-204 unterteilt.

Die Heizfilamente 201 und 205, 202 und 206, 203 und 207, sowie 204 und 208 sind parallel geschaltet. Parallel geschaltete Heizfilament werden mit den gleichen Werten für die Betriebsparameter Betriebsspannung, Betriebsstrom und Betriebsleistung betrieben. Die Heizfilamente bestrahlen somit ein aus zwei identischen Teilfeldern zusammengesetztes Bestrahlungsfeld (nicht dargestellt).

Beispiel 1

Die Bestrahlungsvorrichtung umfasst vier Infrarotstrahler mit insgesamt acht Filamenten. Jeder Infrarotstrahler ist für eine Nennspannung von 230 V, eine Nennleistung von 2.620 W bei einer Nenntemperatur von 2.600 °C ausgelegt. Die beheizte Filamentlänge beträgt 350 mm.

Bei einer vorgegebenen Gesamtbestrahlungsstärke von 5850 W ermöglicht eine Variation der Betriebsspannung $U_i$ und der Anzahl der beleuchteten Strahler n wie in Tabelle 1 gezeigt eine Anpassung des Strahlungsspektrums. Dabei gibt $P_i$ die Betriebsleistung eines Filaments, $P_{ges}$ die Gesamtbestrahlungsleistung, $T$ die Filamenttemperatur, $\lambda_{max}$ die Wellenlänge der Hauptemissionslinie und $P_i/P_{nenn}$ das prozentuale Verhältnis von Einzelbetriebsleistung zur Nennleistung wieder.

Tabelle 1

| Variante | $U_i$ [V] | $P_i$ [W] | n | $P_{ges}$ [W] | T [°C] | $\lambda_{max}$ [nm] | $P_i/P_{nenn}$ [%] |
|---|---|---|---|---|---|---|---|
| 1 | 100 | 710 | 8 | 5680 | 1.830 | 1.375 | 27,1 |
| 2 | 160 | 1.480 | 4 | 5.920 | 2.250 | 1.150 | 56,5 |
| 3 | 250 | 3.000 | 2 | 6.000 | 2.700 | 1.000 | 114,5 |
| 4 | 190 | 1.930 | 3 | 5.790 | 2.415 | 1.080 | 73,7 |

Wie Tabelle 1 zeigt, kann eine nahezu konstante Gesamtbestrahlungsleistung von etwa 5.850 W $\pm$ 3 % durch Variation der Betriebsspannung $U_i$ und der Anzahl n der beleuchteten Filamente erreicht werden. Das Emissionsspektrum der Bestrahlungsvorrichtung kann daher jederzeit an ein neues Substrat angepasst werden. Das aufwändige Umrüsten von Strahlern entfällt.

In der nachfolgenden Tabelle 2 ist der jeweiligen Strahlertemperatur der Anteil der Energie in den Spektralbereichen VIS (380 nm - 780 nm), IR-A (780 nm - 1.400 nm) und IR-B (1.400 nm - 3.000 nm) gegenübergestellt.

Tabelle 2

| Variante | T [°C] | VIS 380 - 780 nm | IR-A 780 - 1.400 nm | IR-B 1.400 - 3.000 nm |
|---|---|---|---|---|
| 1 | 1.830 | 2,2 % | 22,7 % | 50,5 % |
| 2 | 2.250 | 6,0 % | 31,6 % | 45,5 % |
| 3 | 2.700 | 8,0 % | 34,3 % | 43,0 % |
| 4 | 2.415 | 12,0 % | 37,6 % | 38,7 % |

Beispiel 2

Eine Bestrahlungsvorrichtung zum Trocknen und Sintern von Tinten umfasst ein Infrarot-Strahlermodul mit 12 Zwillingsrohr-Infrarotstrahlern mit jeweils 2 Filamenten. Die Anzahl der Filamente beträgt insgesamt 24. Wie die nachfolgende Tabelle 3 zeigt, konnten mit dem Strahlermodul durch unterschiedliche Schaltung der Filamente verschiedene Farbtemperaturen bei einer annähernd konstanten Leistungsdichte von 120 kW/m$^2$ erzielt werden.

Tabelle 3

| Variante | Ui [V] | n | T [°C] | Leistungsdichte Strahlerfeld [kW/m$^2$] |
|---|---|---|---|---|
| 1 | 230 | 8 | 2.600 | 124 |
| 2 | 160 | 12 | 2.250 | 111 |

(fortgesetzt)

| Variante | Ui [V] | n | T [°C] | Leistungsdichte Strahlerfeld [kW/m$^2$] |
|----------|--------|---|--------|------------------------------------------|
| 3 | 110 | 22 | 1.910 | 115 |

Als Substrate wurden sowohl eine Plastikfolie aus Polyethylennaphthalat (PEN) als auch eine Plastikfolie aus Polyethylenterephthalat (PET) mit jeweils einer Foliendicke von 100 $\mu$m verwendet. Die Plastikfolien wurden mit einem Tintenstrahldruck (Dimatix DMP283; Dropspace 25/30 $\mu$m) mit silberhaltiger Tinte bedruckt. Als Tinte wurde eine Dispersion von Silber-Nanopartikeln (20 Gew.-%) in organischen Lösungsmitteln verwendet (Suntronic® Jet Silver U 5603).

Die bedruckten Plastikfolien wurden anschließend von der Bestrahlungsvorrichtung getrocknet. Hierzu wurde die Folie zum Trocknen und Sintern der Tintenschicht wird in Transportrichtung mit einer Bandgeschwindigkeit relativ zum Infrarot-Strahlermodul bewegt. Hierbei konnten Bahngeschwindigkeiten von bis zu 60 m/min erzielt werden.

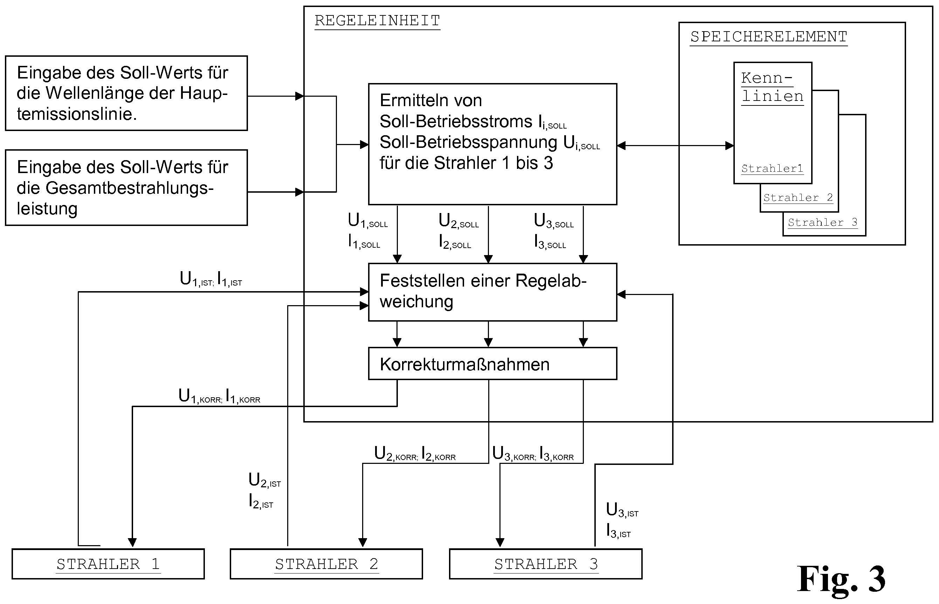

**Figur 3** zeigt in schematischer Darstellung ein Ablaufdiagramm eines erfindungsgemäßen Betriebsverfahrens, das beispielsweise der Vorrichtung zur Bestrahlung eines Substrats gemäß Figur 1 zugrunde liegt. Zur Vereinfachung zeigt Figur 3 allerdings nur eine Bestrahlungsvorrichtung mit drei unabhängig voneinander betreibbaren Infrarotstrahlern (Strahler 1-3), an der das Betriebsverfahren nachfolgend näher erläutert ist. Die Strahler 1-3 werden jeweils mit einer konstanten Betriebsleistung betrieben.

Zunächst wird der Bestrahlungsprozess auf das zu bestrahlende Substrat abgestimmt. In der Regel gibt das Substrat dabei das zu wählende Strahlungsspektrum und die zu wählende Gesamtbestrahlungsleistung vor. Da die Bestrahlung mit einer vorgegebenen Gesamtbestrahlungsleistung und einem vorgegebenen Strahlungsspektrum erfolgen soll, werden Soll-Werte hierfür vorgegeben und an der Regeleinheit eingegeben. Das Strahlungsspektrum ist im Wesentlichen durch die Wellenlänge der Hauptemissionslinie charakterisiert, so dass hier nur die Hauptemissionslinie eingegeben wird. In einer alternativen Ausführungsform (nicht dargestellt) können auch ein oder mehrere vorgegebene Spektralbereiche berücksichtigt werden.

Ausgehend von diesen Werten ermittelt die Regeleinheit die jeweiligen Betriebsleistungen der Infrarotstrahler $P_1$, $P_2$ und $P_3$, sowie die zugehörigen Soll-Betriebsströme $I_{1,SOLL}$, $I_{2,SOLL}$ und $I_{3,SOLL}$ und Soll-Betriebsspannungen $U_{1,SOLL}$, $U_{2,SOLL}$ und $U_{3,SOLL}$. Die Regeleinheit weist ein Speicherelement auf, in dem Strom-Spannungs-Kennlinien der Strahler 1-3 hinterlegt sind; sie berücksichtigt die Kennlinien bei der Ermittlung der Soll-Werte der jeweiligen Betriebsleistungen der Strahler 1-3. Das Ermitteln der Soll-Werte der einzelnen Strahlerbetriebsleistungen erfolgt unter der Maßgabe, dass die jeweilige Strahlerbetriebsleistung entweder 0% der Nennleistung des Infrarotstrahlers beträgt oder im Bereich zwischen 50% bis einschließlich 100% der Nennleistung liegt. Hierdurch ist es beispielsweise möglich einen der Strahler 1-3 auszuschalten während die anderen Strahler mit einer Betriebsleistung in oben genanntem Bereich betrieben werden. In einer alternativen Ausführungsform beträgt die die jeweilige Strahlerbetriebsleistung entweder 0% der Nennleistung des Infrarotstrahlers oder sie liegt im Bereich von 15 bis einschließlich 100% der Nennleistung.

Die Strahler 1-3 werden von der Regeleinheit mit einer Spannung und einem Strom betrieben. Die Betriebsleistung der Strahler 1-3 wird dabei von der Regeleinheit auf den zuvor ermittelten Soll-Wert geregelt, so dass die Strahler 1-3 ein Bestrahlungsfeld auf der Oberfläche mit einer Gesamtbestrahlungsleistung bestrahlen, die von einem vorgegebenen Soll-Wert der Gesamtbestrahlungsleistung um maximal 15% abweicht.

Regelabweichungen der einzelnen Betriebsleistungen der Strahler 1-3 werden von der Regeleinheit erfasst, indem die Betriebsspannungen und Betriebsströme der Strahler 1-3 fortlaufend kontrolliert werden. Festgestellte Regelabweichungen werden durch die Regeleinheit dadurch korrigiert, dass die Strahler 1-3 mit angepasster Spannung $U_{1,KORR}$, $U_{2,KORR}$, $U_{3,KORR}$ und angepasstem Strom $I_{1,KORR}$, $I_{2,KORR}$, $I_{3,KORR}$ betrieben werden.

Die Strahler 1-3 bestrahlen eine Bestrahlungszone.

In einer alternativen Ausgestaltung des Betriebsverfahren (nicht dargestellt) ist das Substrat mit metallhaltiger Tinte versehen und es wird zum Trocknen und Sintern der Tinte bestrahlt. In der Bestrahlungseinheit sind drei zusätzliche Strahler 4-6, die eine zweite Bestrahlungszone bestrahlen, sowie drei weitere Strahler 7-9 vorgesehen, die eine dritte Bestrahlungszone bestrahlen. Die Regeleinheit regelt die jeweiligen Betriebsleistungen der Strahler 1-9 derart, dass ein Bestrahlungsfeld mit drei unterschiedlichen Zonen, nämlich der ersten Bestrahlungszone, der zweiten Bestrahlungszone und der dritten Bestrahlungszone erzeugt wird. Die erste Bestrahlungszone ist eine Trocknungszone zur Trocknung der metallhaltigen Tinte. Die dritte Bestrahlungszone ist eine Sinterzone, in der die metallhaltige Tinte gesintert wird. Trocknungszone und Sinterzone unterscheiden sich in der Bestrahlungsdichte. Die Bestrahlungsdichten beider Zonen sind an die Eigenschaften der metallhaltigen Tinte angepasst. Die Bestrahlungsdichte der Trocknungszone ist geringer als die Bestrahlungsdichte der Sinterzone. Die zweite Bestrahlungszone ist eine Übergangszone, die zwischen Trocknungszone und Sinterzone angeordnet ist und deren Bestrahlungsdichte im Bereich zwischen der Bestrahlungsdichte der Trocknungszone und der Bestrahlungsdichte der Sinterzone liegt.

**Patentansprüche**

1. Verfahren zum Betreiben einer Vorrichtung (100) zur Modifizierung eines Substrats (103) durch Bestrahlen mit Infrarotstrahlung, aufweisend eine Bestrahlungseinheit, in der mehrere zylinderförmige Infrarotstrahler (102) mit parallel zueinander angeordneten Längsachsen zusammengefasst sind, umfassend die Verfahrensschritte:

   • Vorgeben eines Soll-Werts einer Gesamtbestrahlungsleistung in Abhängigkeit von der zu erzielenden Modifizierung des Substrats (103), und
   • Betreiben der Infrarotstrahler (102) mit einer jeweiligen Soll-Betriebsleistung,

   **dadurch gekennzeichnet, dass** in Abhängigkeit von der zu erzielenden Modifizierung des Substrats (103) ein Soll-Strahlungsspektrum vorgegeben wird, die jeweiligen Soll-Betriebsleistungen der Infrarotstrahler (102) von einer Regeleinheit ermittelt und individuell gewählt und die Betriebsleistungen der Infrarotstrahler (102) mit der Regeleinheit auf die jeweilige Soll-Betriebsleistung geregelt werden, so dass sich aus ihrer Addition das Soll-Strahlungsspektrum und eine Gesamtbestrahlungsleistung ergibt, die von dem vorgegebenen Soll-Wert der Gesamtbestrahlungsleistung um maximal 15 % abweicht, wobei die Infrarotstrahler (102) baugleich sind.

2. Betriebsverfahren nach Anspruch 1, **dadurch gekennzeichnet, dass** die Infrarotstrahler (102) eine Nennleistung aufweisen, und dass die jeweiligen Soll-Betriebsleistungen entweder 0% der Nennleistung betragen oder im Bereich von 15% bis einschließlich 100% der Nennleistung liegen.

3. Betriebsverfahren nach Anspruch 1 oder 2, **dadurch gekennzeichnet, dass** die Infrarotstrahler (102) jeweils Strahlung (105) mit einem Anteil an IR-A-Strahlung von mindestens 25% und IR-B-Strahlung von mindestens 25% bezogen auf die gesamte Strahlungsleistung des jeweiligen Infrarotstrahlers (102) emittieren.

4. Betriebsverfahren nach einem der vorhergehenden Ansprüche, **dadurch gekennzeichnet, dass** die Vorrichtung (100) unbeleuchtete Infrarotstrahler (102) und beleuchtete Infrarotstrahler (102) umfasst, wobei benachbarte beleuchtete Infrarotstrahler (102) einen Beleuchtungsabstand zueinander aufweisen, wobei die Varianz des Mittelwerts der Beleuchtungsabstände der Vorrichtung (100) ein Minimum einnimmt.

5. Betriebsverfahren nach einem der vorhergehenden Ansprüche, **dadurch gekennzeichnet, dass** die Regeleinheit ein Speicherelement aufweist, in dem Kennlinien der Infrarotstrahler (102) hinterlegt sind, und dass mindestens eine der Kennlinien bei der Ermittlung der jeweiligen Soll-Betriebsleistungen der Infrarotstrahler (102) berücksichtigt wird.

6. Betriebsverfahren nach Anspruch 5, **dadurch gekennzeichnet, dass** die Kennlinien mindestens eine Strom-Spannungs-Kennlinie umfassen, aus der für den jeweiligen Infrarotstrahler (102) der Betriebsstrom $I_i$ ermittelt wird, so dass bei vorgegebener Betriebsspannung $U_i$ und Betrieb einer Anzahl von Infrarotstrahlern $n_i$ die Gesamtbestrahlungsleistung erreicht wird.

7. Betriebsverfahren nach einem der vorhergehenden Ansprüche, **dadurch gekennzeichnet, dass** die mittlere Leistungsdichte auf einer Strahlerebene im Bereich von 20 kW/m$^2$ bis 250 kW/m$^2$ liegt.

8. Betriebsverfahren nach einem der vorhergehenden Ansprüche 1 bis 7, **dadurch gekennzeichnet, dass** das Bestrahlungsfeld mit einer mittleren Bestrahlungsdichte im Bereich von 10 kW/m$^2$ bis 200 kW/m$^2$ bestrahlt wird.

9. Betriebsverfahren nach einem der vorhergehenden Ansprüche, **dadurch gekennzeichnet, dass** das Substrat (103) mit metallhaltiger Tinte versehen ist und zum Trocknen und Sintern der Tinte bestrahlt wird.

10. Vorrichtung (100) zur Modifizierung eines Substrats (103) durch Bestrahlen mit Infrarotstrahlung mit einer Bestrahlungseinheit, in der mehrere zylinderförmige Infrarotstrahler (102) mit parallel zueinander angeordneten Längsachsen zusammengefasst sind, **dadurch gekennzeichnet, dass** zur individuellen Einstellung einer Soll-Betriebsleistung für die jeweiligen Infrarotstrahler (102) eine Regeleinheit vorgesehen ist, die aus einem vorgegebenen Soll-Strahlungsspektrum und einem vorgegebenen Soll-Wert einer Gesamtbestrahlungsleistung die jeweiligen Soll-Betriebsleistungen der Infrarotstrahler (102) individuell ermittelt, so dass sich aus ihrer Addition das Soll-Strahlungsspektrum und eine Gesamtbestrahlungsleistung ergibt, die von dem vorgegebenen Soll-Wert der Gesamtbestrahlungsleistung um maximal 15% abweicht, wobei die Infrarotstrahler (102) baugleich sind.

**Claims**

1. Method for operating a device (100) for modifying a substrate (103) by irradiating with infrared radiation, having an irradiation unit in which a plurality of cylindrical infrared emitters (102) with longitudinal axes arranged in parallel to one another are combined, comprising the method steps:

   • Specifying a target value of a total irradiation power as a function of the modification of the substrate (103) to be achieved, and
   • Operating the infrared emitters (102) with in each case a target operating power,

   **characterized in that** as a function of the modification of the substrate (103) to be achieved, a target radiation spectrum is specified, the respective target operating powers of the infrared emitters (102) are determined and selected individually by a control unit, and the operating powers of the infrared emitters (102) are regulated with the control unit to the respective target operating power so that their addition results in the target radiation spectrum and a total irradiation power that deviates from the specified target value of the total irradiation power by a maximum of 15%, wherein the infrared emitters (102) are structurally identical.

2. Operating method according to Claim 1, **characterized in that** the infrared emitters (102) have a nominal power, and **in that** the respective target operating powers are either 0% of the nominal power or are in the range of 15% up to and including 100% of the nominal power.

3. Operating method according to Claims 1 or 2, **characterized in that** the infrared emitters (102) each emit radiation (105) with a proportion of IR-A radiation of at least 25% and of IR-B radiation of at least 25%, based on the total radiation power of the respective infrared emitter (102).

4. Operating method according to any one of the preceding claims, **characterized in that** the device (100) comprises unilluminated infrared emitters (102) and illuminated infrared emitters (102), wherein adjacent illuminated infrared emitters (102) have an illumination distance between each other, wherein the variance of the average value of the illumination distances of the device (100) assumes a minimum.

5. Operating method according to any one of the preceding claims, **characterized in that** the control unit has a memory element in which characteristic curves of the infrared emitters (102) are stored, and **in that** at least one of the characteristic curves is taken into account in the determination of the respective target operating powers of the infrared emitters (102).

6. Operating method according to Claim 5, **characterized in that** the characteristic curves comprise at least one current-voltage characteristic curve from which the operating current $I_i$ for the respective infrared emitter (102) is determined so that at a specified operating voltage $U_i$ and during operation of a number of infrared emitters $n_i$, the total irradiation power is reached.

7. Operating method according to any one of the preceding claims, **characterized in that** the average power density at an emitter level is in the range of 20 kW/m$^2$ to 250 kW/m$^2$.

8. Operating method according to any one of the preceding Claims 1 to 7, **characterized in that** the irradiation field is irradiated with an average irradiation density in the range of 10 kW/m$^2$ to 200 kW/m$^2$.

9. Operating method according to any one of the preceding claims, **characterized in that** the substrate (103) is provided with metal-containing ink and is irradiated in order to dry and sinter the ink.

10. Device (100) for modifying a substrate (103) by irradiating with infrared radiation with an irradiation unit in which a plurality of cylindrical infrared emitters (102) with longitudinal axes arranged in parallel to one another are combined, **characterized in that** a control unit is provided for the individual adjustment of a target operating power for the respective infrared emitters (102) and individually determines the respective target operating powers of the infrared emitters (102) from a specified target radiation spectrum and a specified target value of a total irradiation power so that their addition results in the target radiation spectrum and a total irradiation power that deviates from the specified target value of the total irradiation power by a maximum of 15%, wherein the infrared emitters (102) are structurally identical.

**Revendications**

1. Procédé de fonctionnement d'un dispositif (100) de modification d'un substrat (103) par irradiation avec un rayonnement infrarouge, présentant une unité d'irradiation, dans lequel plusieurs émetteurs infrarouges (102) cylindriques sont rassemblés avec des axes longitudinaux disposés parallèles les uns aux autres, comprenant les étapes de procédé :

   • de pré définition d'une valeur de consigne d'une puissance de rayonnement totale en fonction de la modification du substrat (103) à obtenir, et
   • de fonctionnement des émetteurs infrarouge (102) avec une puissance de fonctionnement de consigne,

   **caractérisé en ce que,** en fonction de la modification du substrat (103) à obtenir, un spectre de rayonnement de consigne est prédéfini, les puissances de fonctionnement de consigne des émetteurs infrarouge (102) sont déterminées par une unité de réglage et choisies individuellement et les puissances de fonctionnement des émetteurs infrarouge (102) sont réglées par l'unité de réglage à la puissance de fonctionnement de consigne respective, de telle sorte que leur addition donne le spectre de rayonnement de consigne et une puissance de rayonnement totale, laquelle diffère d'au maximum 15 % de la valeur de consigne prédéfinie de la puissance de rayonnement totale, les émetteurs infrarouges (102) étant identiques.

2. Procédé de fonctionnement selon la revendication 1, **caractérisé en ce que** les émetteurs infrarouges (102) présentent une puissance nominale, et **en ce que** les puissances de fonctionnement de consigne respectives s'élèvent à 0 % de la puissance nominale ou se situent dans la plage de 15 %, jusqu'à y compris 100 % de la puissance nominale.

3. Procédé de fonctionnement selon la revendication 1 ou 2, **caractérisé en ce que** les émetteurs infrarouges (102) émettent respectivement un rayonnement (105) avec une part de rayonnement IR-A d'au moins 25 % et de rayonnement IR-B d'au moins 25 % par rapport à la puissance de rayonnement totale de l'émetteur infrarouge (102) respectif.

4. Procédé de fonctionnement selon l'une quelconque des revendications précédentes, **caractérisé en ce que** le dispositif (100) comprend des émetteurs infrarouges (102) non éclairés et des émetteurs infrarouges (102) éclairés, des émetteurs infrarouges (102) éclairés adjacents présentant une distance d'éclairage entre eux, la variance de la moyenne des distances d'éclairage du dispositif (100) prenant un minimum.

5. Procédé de fonctionnement selon l'une quelconque des revendications précédentes, **caractérisé en ce que** l'unité de réglage présente un élément de mémoire, dans lequel des courbes caractéristiques des émetteurs infrarouges (102) sont enregistrées, et **en ce qu'**au moins une des courbes caractéristiques est prise en compte lors de la détermination des puissances de fonctionnement de consigne respectives des émetteurs infrarouge (102).

6. Procédé de fonctionnement selon la revendication 5, **caractérisé en ce que** les courbes caractéristiques comprennent au moins une courbe caractéristique de courant et de tension, à partir de laquelle le courant de fonctionnement $I_i$ est déterminé pour l'émetteur infrarouge (102) respectif, de sorte que la puissance de rayonnement totale est atteinte pour une tension de fonctionnement $U_i$ prédéfinie et le fonctionnement d'un nombre d'émetteurs infrarouge $n_i$.

7. Procédé de fonctionnement selon l'une quelconque des revendications précédentes, **caractérisé en ce que** la densité de puissance moyenne se situe sur un plan d'émetteur dans la plage de 20 kW/m$^2$ à 250 kW/m$^2$.

8. Procédé de fonctionnement selon l'une quelconque des revendications 1 à 7, **caractérisé en ce que** la densité de puissance moyenne se situe sur un plan d'émetteur dans la plage de 10 kW/m$^2$ à 200 kW/m$^2$.

9. Procédé de fonctionnement selon l'une quelconque des revendications précédentes, **caractérisé en ce que** le substrat (103) est doté d'encre contenant un métal et est irradié pour le séchage et le frittage de l'encre.

10. Dispositif (100) de modification d'un substrat (103) par irradiation avec un rayonnement infrarouge, dans lequel plusieurs émetteurs infrarouges (102) cylindriques sont rassemblés avec des axes longitudinaux disposés parallèles les uns aux autres, **caractérisé en ce que,** pour le réglage d'une puissance de fonctionnement de consigne pour les émetteurs infrarouges (102) respectifs, une unité de réglage est prévue, laquelle, à partir d'un spectre de rayonnement de consigne prédéfini et d'une valeur de consigne prédéfinie d'une puissance de rayonnement totale, détermine individuellement les puissances de fonctionnement de consigne des émetteurs infrarouge (102), de telle sorte que leur addition donne le spectre de rayonnement de consigne et une puissance de rayonnement totale qui diffère au maximum de 15 % de la valeur de consigne prédéfinie de la puissance de rayonnement totale, les émetteurs infrarouges (102) étant identiques.

**Fig. 1**

**Fig. 2**

REGELEINHEIT

SPEICHERELEMENT

Eingabe des Soll-Werts für die Wellenlänge der Haup-temissionslinie.

Eingabe des Soll-Werts für die Gesamtbestrahlungs-leistung

Ermitteln von
Soll-Betriebsstroms $I_{i,SOLL}$
Soll-Betriebsspannung $U_{i,SOLL}$
für die Strahler 1 bis 3

Kenn-linien

Strahler1

Strahler 2

Strahler 3

$U_{1,SOLL}$ $I_{1,SOLL}$   $U_{2,SOLL}$ $I_{2,SOLL}$   $U_{3,SOLL}$ $I_{3,SOLL}$

$U_{1,IST;}$ $I_{1,IST}$

Feststellen einer Regelab-weichung

Korrekturmaßnahmen

$U_{1,KORR;}$ $I_{1,KORR}$

$U_{2,KORR;}$ $I_{2,KORR}$   $U_{3,KORR;}$ $I_{3,KORR}$

$U_{2,IST}$
$I_{2,IST}$

$U_{3,IST}$
$I_{3,IST}$

STRAHLER 1

STRAHLER 2

STRAHLER 3

**Fig. 3**

EP 3 005 413 B1

## IN DER BESCHREIBUNG AUFGEFÜHRTE DOKUMENTE

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 10051125 A1
- US 20100003021 A1
- EP 2059089 A2
- DE 10145648 A1

**In der Beschreibung aufgeführte Nicht-Patentliteratur**

- **Z. RADIVOJEVIC et al.** Optimised curing of silver ink jet based printed traces. *Proceedings of 12th International Workshop on Thermal Investigations of ICs -Therminic 2006, Nice: France,* 2006
- **R. CAUCHOIS et al.** Impact of variable frequency microwave and rapid thermal sintering on microstructure of inkjet-printed silver nanoparticles. *J. Mat. Sci,* 2012, vol. 47, 20
- Photonic Sintering of Silver Nanoparticles: Comparison of Experiment and Theory. **J. WEST et al.** Sintering-Methods and Products. InTech, 2012
- **A. KHAN et al.** Laser sintering of direct write silver nano-ink conductors for microelectronic applications. *Proc. SPIE,* 2008, 6879